# EUROPEAN PATENT APPLICATION

(11) **EP 4 495 623 A1**
(43) Date of publication of application: **22.01.2025**
(21) Application number: 24153872.7
(22) Date of filing: 25.01.2024
(51) Int. Cl.: G01S 7/481, G01S 7/484, H01S 5/042, H01S 5/183

(54) **INFORMATION PROCESSING SYSTEM, INFORMATION PROCESSING METHOD, AND PROGRAM**

(30) Priority: 19.07.2023 JP 2023117858
(71) Applicant: FUJIFILM Business Innovation Corp., Minato-ku Tokyo (JP)
(72) Inventor: TATEISHI, Naohiro, Yokohama-shi, Kanagawa (JP); UMEKAWA, Hideyuki, Ebina-shi, Kanagawa (JP); OHSAWA, Chizuru, Ebina-shi, Kanagawa (JP); KIMURA, Rio, Ebina-shi, Kanagawa (JP)
(74) Representative: Kurig, Thomas

(57) **Abstract**

An information processing system includes an optical sensor that has multiple light emitting regions capable of emitting light independently, the optical sensor causing at least one light emitting region of the multiple light emitting regions to emit light to radiate the light onto a detection range split into multiple regions, the optical sensor being capable of detecting a distance to a target within the detection range for each region of the detection range by receiving light reflected from the target; and a processor configured to control the optical sensor such that the multiple light emitting regions sequentially emit light in accordance with a light emission sequence in which adjacent light emitting regions do not successively emit light if the target is not detected within the detection range.

## Description

### Background

### (i) Technical Field

The present disclosure relates to information processing systems, information processing methods, and programs.

### (ii) Related Art

Japanese Patent No. 6875790 discloses a distance measuring device capable of providing data for determining whether there is an obstacle by a simple calculation involving splitting distance measurement data acquired at all scan angles in a detection area into sub areas of multiple scan angles and comparing the value of the distance measurement data in each sub area with a predetermined value.

### Summary

It is demanded that a target entering a detection range be detected quickly by using a human sensor. By using an optical sensor as the human sensor and splitting the detection range into multiple regions, it is possible to detect which region the target has entered.

However, splitting the detection range into multiple regions and successively detecting the multiple regions sequentially from an end of the detection range may consume too much time for detecting the target.

Accordingly, it is an object of the present disclosure to provide an information processing system, an information processing method, and a program that may shorten the time consumed until the target is detected, as compared with the case where the multiple regions are successively detected sequentially from the end of the detection range.

According to a first aspect of the present disclosure, there is provided an information processing system including an optical sensor that has a plurality of light emitting regions capable of emitting light independently, the optical sensor causing at least one light emitting region of the plurality of light emitting regions to emit light to radiate the light onto a detection range split into a plurality of regions, the optical sensor being capable of detecting a distance to a target within the detection range for each region of the detection range by receiving light reflected from the target; and a processor configured to control the optical sensor such that the plurality of light emitting regions sequentially emit light in accordance with a light emission sequence in which adjacent light emitting regions do not successively emit light if the target is not detected within the detection range.

According to a second aspect of the present disclosure, in the information processing system according to the first aspect, the processor may be configured to divide the plurality of light emitting regions into a plurality of groups and cause light emitting regions located at identical positions in the respective groups to emit light in sequence for each group, so as to cause the plurality of light emitting regions to emit light sequentially in accordance with the light emission sequence in which adjacent light emitting regions do not successively emit light.

According to a third aspect of the present disclosure, in the information processing system according to the second aspect, the processor may be configured to perform control to cause the light emitting regions to emit light sequentially from an end in each group.

According to a fourth aspect of the present disclosure, in the information processing system according to the first aspect, the processor may be configured to divide the plurality of light emitting regions into a plurality of groups and cause light emitting regions located at identical positions in the respective groups to simultaneously emit light in sequence, so as to cause the plurality of light emitting regions to emit light sequentially in accordance with the light emission sequence in which adjacent light emitting regions do not successively emit light.

According to a fifth aspect of the present disclosure, in the information processing system according to any one of the first to fourth aspects, the processor may be configured to perform control such that any one light emitting region of the plurality of light emitting regions and light emitting regions adjacent to the one light emitting region at opposite sides thereof sequentially emit light if the target is detected in the one light emitting region and the distance to the optical sensor subsequently becomes shorter than when the target is detected in the one light emitting region.

According to a sixth aspect of the present disclosure, in the information processing system according to the fifth aspect, the processor may be configured to perform control such that the plurality of light emitting regions sequentially emit light in accordance with the light emission sequence in which adjacent light emitting regions do not successively emit light if the distance to the optical sensor becomes longer while the one light emitting region and the light emitting regions adjacent to the one light emitting region at the opposite sides thereof are sequentially emitting the light.

According to a seventh aspect of the present disclosure, in the information processing system according to the fifth aspect, the processor may be configured to perform control such that the plurality of light emitting regions sequentially emit light in accordance with the light emission sequence in which adjacent light emitting regions do not successively emit light if the distance to the optical sensor does not change for a predetermined time period or longer while the one light emitting region and the light emitting regions adjacent to the one light emitting region at the opposite sides thereof are sequentially emitting the light.

According to an eighth aspect of the present disclosure, there is provided a program causing a computer to execute a process, the process including: causing an optical sensor that has a plurality of light emitting regions capable of emitting light independently to emit light from at least one light emitting region of the plurality of light emitting regions to radiate the light onto a detection range split into a plurality of regions, and detecting a distance to a target within the detection range for each region of the detection range by receiving light reflected from the target; and controlling the optical sensor such that the plurality of light emitting regions sequentially emit light in accordance with a light emission sequence in which adjacent light emitting regions do not successively emit light if the target is not detected within the detection range.

According to an ninth aspect of the present disclosure, there is provided an information processing method comprising: causing an optical sensor that has a plurality of light emitting regions capable of emitting light independently to emit light from at least one light emitting region of the plurality of light emitting regions to radiate the light onto a detection range split into a plurality of regions, and detecting a distance to a target within the detection range for each region of the detection range by receiving light reflected from the target; and controlling the optical sensor such that the plurality of light emitting regions sequentially emit light in accordance with a light emission sequence in which adjacent light emitting regions do not successively emit light if the target is not detected within the detection range.

According to the information processing system according to the first aspect of the present disclosure, the time consumed until the target is detected may be shortened, as compared with a case where the multiple regions are successively detected sequentially from an end of the detection range.

According to the information processing system according to the second aspect of the present disclosure, the time consumed until the target is detected may be shortened, as compared with a case where the multiple regions are successively detected sequentially from an end of the detection range.

According to the information processing system according to the third aspect of the present disclosure, the time consumed until the target is detected may be shortened, as compared with a case where the multiple regions are successively detected sequentially from an end of the detection range.

According to the information processing system according to the fourth aspect of the present disclosure, the time consumed until the target is detected may be shortened, as compared with a case where the multiple regions are successively detected sequentially from an end of the detection range.

According to the information processing system according to the fifth aspect of the present disclosure, the target may be readily detected.

According to the information processing system according to the sixth aspect of the present disclosure, another target may be readily detected assuming that the possibility of the detected target being a user is low.

According to the information processing system according to the seventh aspect of the present disclosure, another target may be readily detected assuming that the possibility of the detected target being a user is low.

According to the program according to the eighth aspect of the present disclosure, the time consumed until the target is detected may be shortened, as compared with a case where the multiple regions are successively detected sequentially from an end of the detection range.

According to the information processing method according to the ninth aspect of the present disclosure, the time consumed until the target is detected may be shortened, as compared with a case where the multiple regions are successively detected sequentially from an end of the detection range.

### Brief Description of the Drawings

An exemplary embodiment of the present disclosure will be described in detail based on the following figures, wherein:
Fig. 1 is an external view schematically illustrating the configuration of an image forming apparatus according to an exemplary embodiment;
Fig. 2 is a front view schematically illustrating the configuration of an optical sensor;
Fig. 3 schematically illustrates the configuration of a vertical cavity surface emitting laser (VCSEL) array;
Fig. 4 is an optical path diagram, in an X-Z plane, of light beams output from the VCSEL array;
Fig. 5 is a block diagram illustrating a hardware configuration of the image forming apparatus;
Fig. 6 is a block diagram illustrating a functional configuration of the image forming apparatus;
Fig. 7 illustrates a detection sequence of regions in a detection range of the optical sensor split into multiple regions; and
Fig. 8 illustrates a detection sequence of the regions in the detection range of the optical sensor split into multiple regions.

### Detailed Description

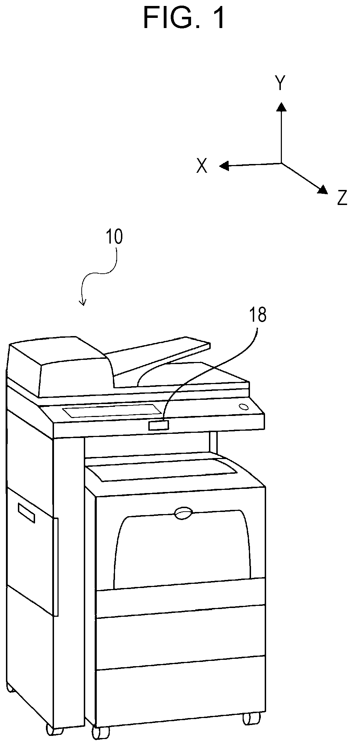

An exemplary embodiment of the present disclosure will be described in detail below with reference to the drawings. Fig. 1 is an external view schematically illustrating the configuration of an image forming apparatus 10 according to this exemplary embodiment. An X axis, a Y axis, and a Z axis in Fig. 1 indicate coordinate axes of the image forming apparatus 10. An X-axis direction is a horizontal direction and indicates a width direction of the image forming apparatus 10, a Y-axis direction is a vertical direction and indicates an up-down direction of the image forming apparatus 10, and a Z-axis direction is a horizontal direction and indicates a depth direction of the image forming apparatus 10.

As illustrated in Fig. 1, the image forming apparatus 10 is a so-called multifunction apparatus having multiple functions, such as a printing function, a scanning function, a copying function, and a facsimile function. The image forming apparatus 10 is an example of an information processing system according to the technology of the present disclosure.

The image forming apparatus 10 includes an optical sensor 18 that detects a user using the image forming apparatus 10. Because the user normally approaches a location where the image forming apparatus 10 is installed, the optical sensor 18 is set to detect such a user.

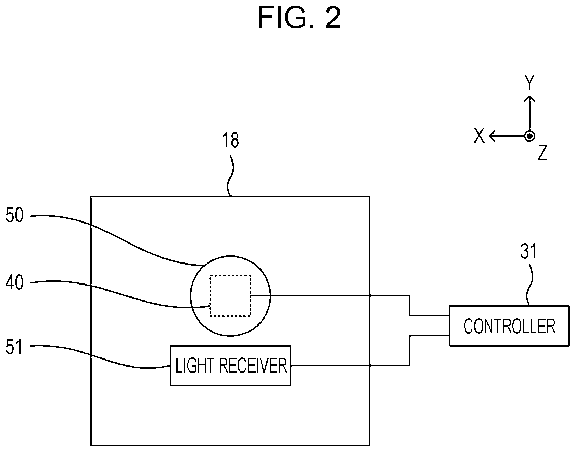

Fig. 2 is a front view schematically illustrating the configuration of the optical sensor 18. As illustrated in Fig. 2, the optical sensor 18 includes a vertical cavity surface emitting laser (VCSEL) array 40 having multiple light emitting regions B, an optical system 50 that deflects light beams emitted from the multiple light emitting regions B in different directions, and a light receiver 51 that detects reflection light of light output from the optical system 50.

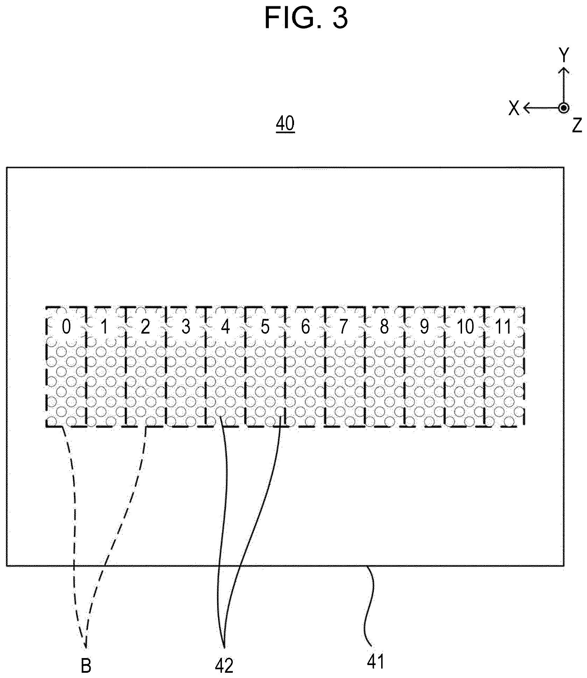

Fig. 3 schematically illustrates the configuration of the VCSEL array 40. As illustrated in Fig. 3, the VCSEL array 40 has multiple VCSEL light emitting elements 42 arranged in a staggered layout in a partial region on a substrate 41.

The VCSEL array 40 has the multiple light emitting regions B arranged in the X-axis direction. The VCSEL array 40 has multiple light emitting elements 42 within each light emitting region B. In the VCSEL array 40, the light emitting elements 42 are on or off controlled in each light emitting region B. Fig. 3 illustrates an example where 12 light emitting regions B are arranged in the X-axis direction, and the 12 light emitting regions B are respectively given numbers from 0 to 11.

The optical system 50 is disposed in a light output direction of the VCSEL array 40 and deflects the light beams emitted from the multiple light emitting regions B in different directions. The optical system 50 is disposed such that the optical axis of the optical system 50 is orthogonal to the center position of all the light emitting regions B of the VCSEL array 40.

The optical system 50 is constituted of, for example, a lens. In the case where the optical system 50 is constituted of a lens, the shape of the lens and the number of lenses are not particularly limited, and any configuration may be employed so long as the light beams emitted from the multiple light emitting regions B are deflectable in different directions.

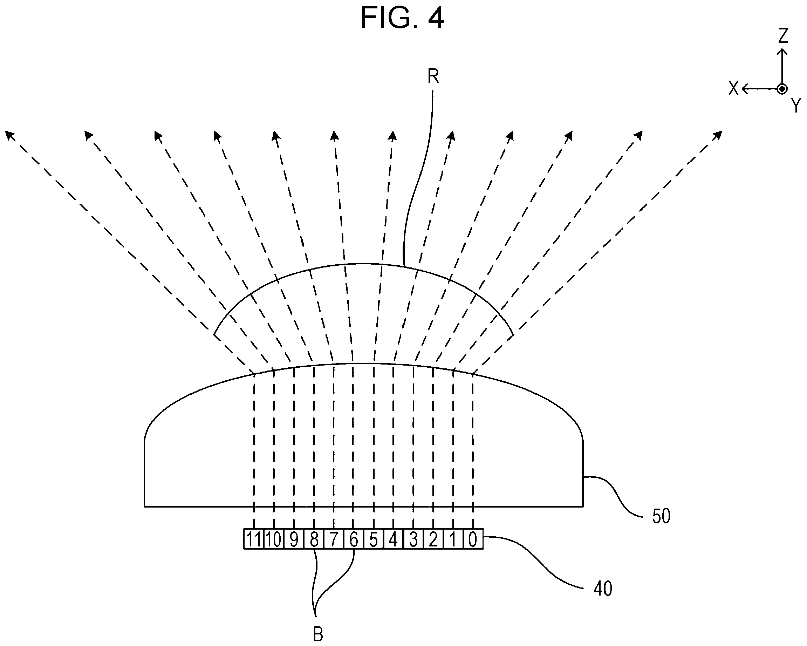

Fig. 4 is an optical path diagram, in an X-Z plane, of light beams output from the VCSEL array 40. Specifically, Fig. 4 is a schematic diagram for facilitating the explanation of the configuration and does not illustrate the actual shapes of the VCSEL array 40 and the optical system 50. As illustrated in Fig. 4, in this exemplary embodiment, the VCSEL array 40 has 12 light emitting regions B arranged in the X-axis direction.

The optical system 50 deflects the light beams emitted from the 0-th to 11-th light emitting regions B in different directions. A light irradiation angle of the optical sensor 18 is an angle formed between output directions, from the optical system 50, of two light beams emitted from the outermost light emitting regions B.

The light irradiation angle of the optical sensor 18 in this exemplary embodiment is an angle R between the output direction, from the optical system 50, of the light beam emitted from the outermost 0-th light emitting region B and the output direction, from the optical system 50, of the light beam emitted from the outermost 11-th light emitting region B at the opposite side. The light irradiation angle of the optical sensor 18 in this exemplary embodiment is 120° as an example.

The light receiver 51 includes a light receiving element, such as a photodetector. The number of light receiving elements is not limited to one, and multiple light receiving elements may be provided.

The optical sensor 18 is disposed within the image forming apparatus 10 such that the X-axis direction is the horizontal direction of the image forming apparatus 10 and that the Y-axis direction is the vertical direction of the image forming apparatus 10.

The optical sensor 18 is controlled by a controller 31 of the image forming apparatus 10. The controller 31 of the image forming apparatus 10 will be described in detail later.

As mentioned above, the optical sensor 18 has multiple light emitting regions B capable of emitting light independently. The optical sensor 18 causes at least one light emitting region B of the multiple light emitting regions B to emit light to radiate the light onto a detection range split into multiple regions, and is capable of detecting the distance from a target within the detection range for each region of the detection range by receiving light reflected from the target.

The image forming apparatus 10 according to this exemplary embodiment uses this optical sensor 18 to detect the user using the image forming apparatus 10, thereby performing control of the operation mode, including restoring the image forming apparatus 10 from a power-saving mode to a normal operation mode.

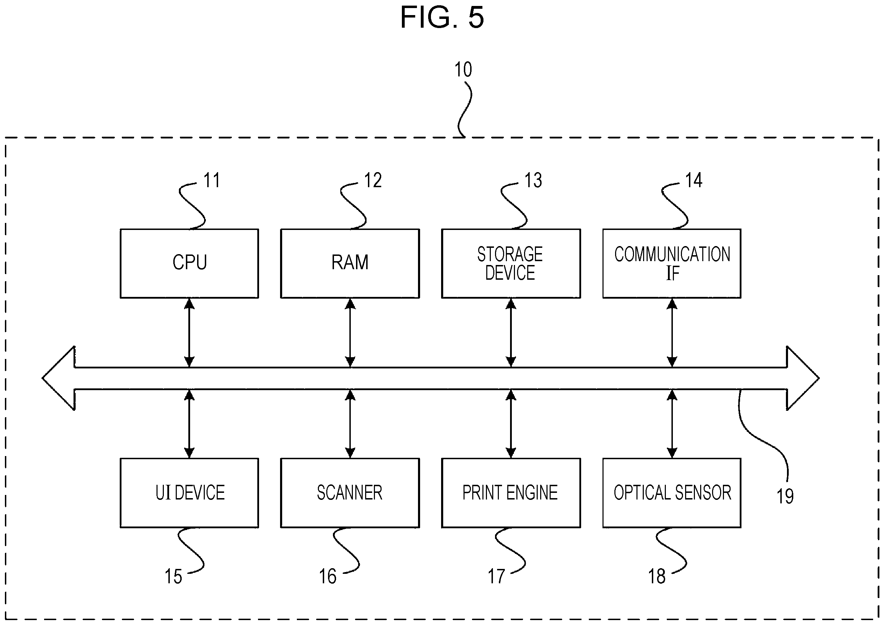

Next, a hardware configuration of the image forming apparatus 10 according to this exemplary embodiment will be described. Fig. 5 is a block diagram illustrating the hardware configuration of the image forming apparatus 10.

As illustrated in Fig. 5, the image forming apparatus 10 has a central processing unit (CPU) 11, a random access memory (RAM) 12, a storage device 13, such as a hard disk drive, a communication interface (IF) 14, a user interface (UI) device 15 including a touchscreen or a liquid crystal display and a keyboard, a scanner 16, a print engine 17, and the optical sensor 18. These components are connected to one another by a control bus 19.

The CPU 11 is a processor that executes predetermined processing based on a control program stored in the RAM 12 or the storage device 13 to control the operation of the image forming apparatus 10. In this exemplary embodiment, the CPU 11 is described as being configured to read and execute the control program stored in the RAM 12 or the storage device 13, but is not limited thereto. The control program may be provided by being stored in a computer readable storage medium. For example, the program may be provided by being stored in an optical disk, such as a compact disc (CD) read-only memory (ROM) or a digital versatile disc (DVD) ROM, or by being stored in a semiconductor memory, such as a universal serial bus (USB) memory or a memory card. Alternatively, the control program may be acquired from an external device via a communication line connected to the communication IF 14.

The communication IF 14 transmits and receives data to and from, for example, an external device. The UI device 15 receives an input of a command from the user. The scanner 16 reads a document loaded in the image forming apparatus 10 as image data. The print engine 17 prints an image onto a recording medium, such as a printing sheet, by performing steps, such as a charging step, an exposure step, a developing step, a transfer step, and a fixing step.

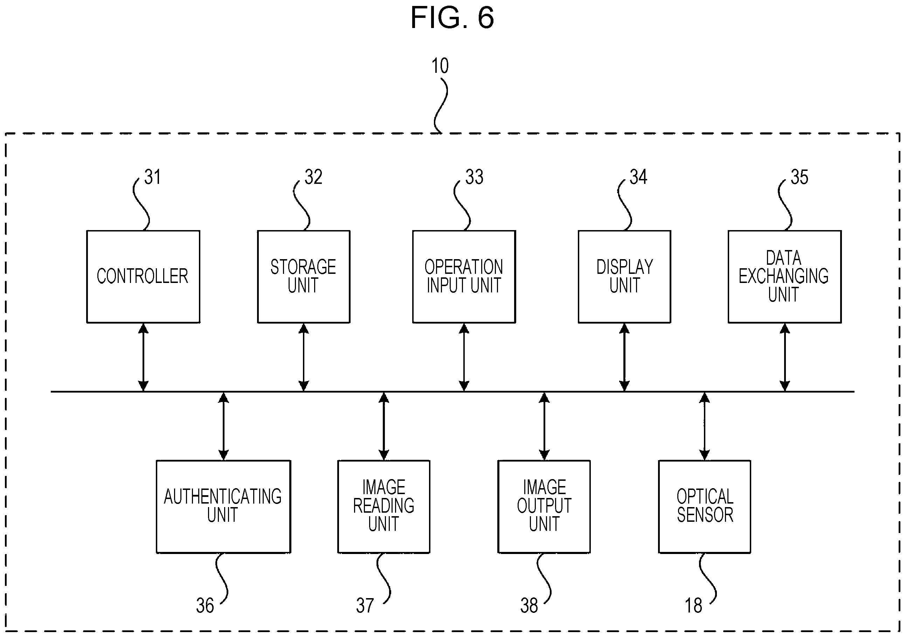

Next, a functional configuration of the image forming apparatus 10 according to this exemplary embodiment will be described. Fig. 6 is a block diagram illustrating the functional configuration of the image forming apparatus 10.

As illustrated in Fig. 6, the image forming apparatus 10 according to this exemplary embodiment includes the controller 31, a storage unit 32, an operation input unit 33, a display unit 34, a data exchanging unit 35, an authenticating unit 36, an image reading unit 37, an image output unit 38, and the optical sensor 18.

The controller 31 controls the overall operation of the image forming apparatus 10. For example, based on an input of a command from the user, the controller 31 performs control for causing the image reading unit 37 to read a document image and control for outputting print data from the image output unit 38. The storage unit 32 stores data, such as the control program.

The operation input unit 33 receives information about various types of operations performed by the user. The display unit 34 is controlled by the controller 31 and displays various types of information to the user. The data exchanging unit 35 exchanges data with an external device. The authenticating unit 36 executes an authentication process with respect to a user attempting to use the image forming apparatus 10.

The image reading unit 37 reads a document image from a loaded document based on control by the controller 31. The image output unit 38 outputs an image onto a recording medium, such as a printing sheet, based on control by the controller 31.

Next, user detection control using the optical sensor 18 of the image forming apparatus 10 will be described in detail.

The controller 31 performs operation control of the VCSEL array 40 and the light receiver 51 and also performs a process for calculating the distance from the optical sensor 18 to the target based on a signal detected in the light receiver 51.

In detail, the controller 31 first causes one light emitting region B of the multiple light emitting regions B arranged in the X-axis direction to output light. Then, the controller 31 causes the light receiver 51 to detect reflection light of the light output from this light emitting region B. Subsequently, based on a signal detected in the light receiver 51, the controller 31 calculates a time difference between the timing at which the light is radiated from the light emitting region B and the timing at which the reflection light is detected by the light receiver 51. Then, based on the calculated time difference, the controller 31 calculates the distance from the optical sensor 18 to the target in the detection range corresponding to this light emitting region B. If reflection light is not detected in the detection range corresponding to this light emitting region B, it is ascertainable that a target does not exist in the detection range.

Upon completion of the target detection process with respect to one light emitting region B, the controller 31 performs the target detection process similarly with respect to the remaining light emitting regions B, thereby performing the detection process in all the detection ranges. Subsequently, the controller 31 repeatedly executes the detection process in all the detection ranges.

In this case, when the detection process is performed in all the detection ranges by causing the multiple light emitting regions B arranged in the X-axis direction in the VCSEL array 40 to emit light sequentially from one end toward the other end, the detection of a target located away from the detection range of the light emitting region B that has emitted the light first may sometimes be delayed.

The light emitting elements 42 of the VCSEL array 40 generate heat by emitting light, and may tend to become damaged due to the heat. Therefore, when adjacent light emitting regions B of the VCSEL array 40 are sequentially turned on, a certain light emitting region B may generate heat during light emission and may subsequently be affected by heat generated from light emission by a neighboring light emitting region B, possibly resulting in a shorter lifespan due to an inability to keep up with heat dissipation.

As a countermeasure against this problem, when a target is not detected within each detection range, the controller 31 of the image forming apparatus 10 according to this exemplary embodiment controls the VCSEL array 40 such that multiple light emitting regions B sequentially emit light in accordance with a light emission sequence in which adjacent light emitting regions B do not successively emit light.

Accordingly, the time consumed until a target is detected may be shortened, as compared with a case where the detection is successively performed sequentially from an end of multiple detection ranges corresponding to multiple light emitting regions B. Moreover, since a neighboring light emitting region B does not emit light immediately after a certain light emitting region B emits light, a temperature increase in the light emitting region B that has emitted the light may be suppressed.

In the image forming apparatus 10 according to this exemplary embodiment, the controller 31 may divide the multiple light emitting regions B into multiple groups and cause light emitting regions located at identical positions in the respective groups to emit light in sequence for each group, so as to cause the multiple light emitting regions B to emit light sequentially in accordance with a light emission sequence in which adjacent light emitting regions B do not successively emit light.

In this case, the controller 31 may perform control to cause the light emitting regions B to emit light sequentially from an end in each group.

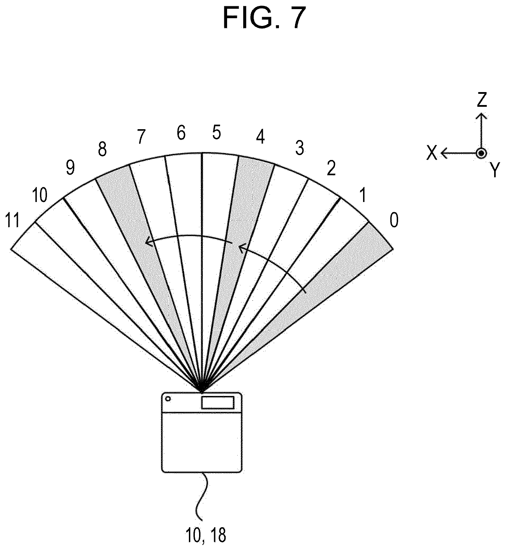

In an example illustrated in Fig. 7, a light emitting region B0 to a light emitting region B3 are defined as a single group, a light emitting region B4 to a light emitting region B7 are defined as a single group, and a light emitting region B8 to a light emitting region B1 1 are defined as a single group. In each group, the light emitting regions B emit light sequentially from the right end.

Specifically, the light emitting region B0, the light emitting region B4, the light emitting region B8, the light emitting region B1, the light emitting region B5, the light emitting region B9, the light emitting region B2, the light emitting region B6, the light emitting region B10, the light emitting region B3, the light emitting region B7, and the light emitting region B11 are turned on in this order.

The controller 31 may divide the multiple light emitting regions B into multiple groups and cause light emitting regions B located at identical positions in the respective groups to simultaneously emit light in sequence, so as to cause the multiple light emitting regions B to emit light sequentially in accordance with a light emission sequence in which adjacent light emitting regions B do not successively emit light.

In the example illustrated in Fig. 7, the light emitting region B0, the light emitting region B4, and the light emitting region B8 may be caused to emit light simultaneously, the light emitting region B1, the light emitting region B5, and the light emitting region B9 may subsequently be caused to emit light simultaneously, the light emitting region B2, the light emitting region B6, and the light emitting region B10 may then be caused to emit light simultaneously, and the light emitting region B3, the light emitting region B7, and the light emitting region B11 may subsequently be caused to emit light simultaneously.

After a target is detected in any one light emitting region B of the multiple light emitting regions B, if the distance to the image forming apparatus 10 equipped with the optical sensor 18 becomes shorter than when the target is detected in the one light emitting region B, the controller 31 may perform control such that the one light emitting region B and the light emitting regions B adjacent to the one light emitting region B at opposite sides thereof sequentially emit light.

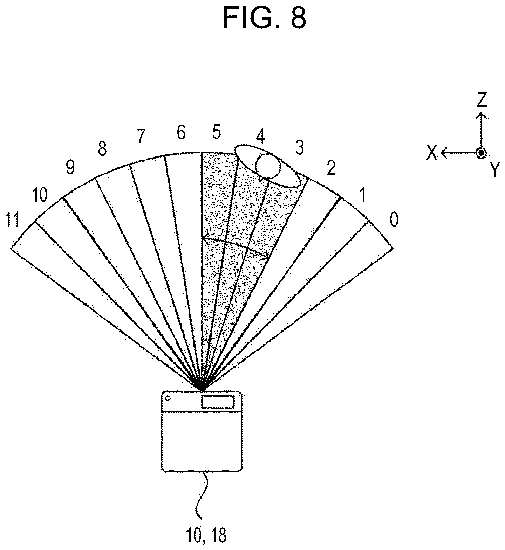

In an example illustrated in Fig. 8, a target is detected in the light emitting region B4. In this case, the light emitting region B4 and the light emitting regions B3 and B5 adjacent to the light emitting region B4 at opposite sides thereof sequentially emit light.

In this case, if the distance to the image forming apparatus 10 becomes longer while the one light emitting region B and the light emitting regions B adjacent to the one light emitting region B at the opposite sides thereof are sequentially emitting the light, the controller 31 may perform control such that the multiple light emitting regions B sequentially emit light in accordance with a light emission sequence in which adjacent light emitting regions B do not successively emit light.

If the distance to the image forming apparatus 10 does not change for a predetermined time period or longer while the one light emitting region B and the light emitting regions B adjacent to the one light emitting region B at the opposite sides thereof are sequentially emitting the light, the controller 31 may perform control such that the multiple light emitting regions B sequentially emit light in accordance with a light emission sequence in which adjacent light emitting regions B do not successively emit light.

### Modifications

Although the information processing system according to the exemplary embodiment of the present disclosure has been described above, the exemplary embodiment of the present disclosure is not limited to the above exemplary embodiment and may be modified, where appropriate.

For example, although the technology of the present disclosure is applied to the image forming apparatus 10 in the above exemplary embodiment, the technology of the present disclosure is not limited to such an apparatus. The technology of the present disclosure may similarly be applied to an information processing system, such as an automatic teller machine (ATM) or a ticket-vending machine, that the user approaches and performs an operation thereon.

In the above exemplary embodiment, the term "system" includes both a system constituted of multiple apparatuses and a system constituted of a single apparatus.

In the exemplary embodiment above, the term "processor" refers to hardware in a broad sense. Examples of the processor include general processors (e.g., CPU: Central Processing Unit) and dedicated processors (e.g., GPU: Graphics Processing Unit, ASIC: Application Specific Integrated Circuit, FPGA: Field Programmable Gate Array, and programmable logic device).

In the exemplary embodiment above, the term "processor" is broad enough to encompass one processor or plural processors in collaboration which are located physically apart from each other but may work cooperatively. The order of operations of the processor is not limited to one described in the embodiments above, and may be changed.

The foregoing description of the exemplary embodiment of the present disclosure has been provided for the purposes of illustration and description. It is not intended to be exhaustive or to limit the disclosure to the precise forms disclosed. Obviously, many modifications and variations will be apparent to practitioners skilled in the art. The exemplary embodiment was chosen and described in order to best explain the principles of the disclosure and its practical applications, thereby enabling others skilled in the art to understand the disclosure for various embodiments and with the various modifications as are suited to the particular use contemplated. It is intended that the scope of the disclosure be defined by the following claims and their equivalents.

### Appendix

(((1))) An information processing system comprising:
   an optical sensor that has a plurality of light emitting regions capable of emitting light independently, the optical sensor causing at least one light emitting region of the plurality of light emitting regions to emit light to radiate the light onto a detection range split into a plurality of regions, the optical sensor being capable of detecting a distance to a target within the detection range for each region of the detection range by receiving light reflected from the target; and
   a processor configured to:
      control the optical sensor such that the plurality of light emitting regions sequentially emit light in accordance with a light emission sequence in which adjacent light emitting regions do not successively emit light if the target is not detected within the detection range.
(((2))) The information processing system according to (((1))),
   wherein the processor is configured to divide the plurality of light emitting regions into a plurality of groups and cause light emitting regions located at identical positions in the respective groups to emit light in sequence for each group, so as to cause the plurality of light emitting regions to emit light sequentially in accordance with the light emission sequence in which adjacent light emitting regions do not successively emit light.
(((3))) The information processing system according to (((2))),
   wherein the processor is configured to perform control to cause the light emitting regions to emit light sequentially from an end in each group.
(((4))) The information processing system according to (((1))),
   wherein the processor is configured to divide the plurality of light emitting regions into a plurality of groups and cause light emitting regions located at identical positions in the respective groups to simultaneously emit light in sequence, so as to cause the plurality of light emitting regions to emit light sequentially in accordance with the light emission sequence in which adjacent light emitting regions do not successively emit light.
(((5))) The information processing system according to any one of (((1))) to (((4))),
   wherein the processor is configured to perform control such that any one light emitting region of the plurality of light emitting regions and light emitting regions adjacent to the one light emitting region at opposite sides thereof sequentially emit light if the target is detected in the one light emitting region and the distance to the optical sensor subsequently becomes shorter than when the target is detected in the one light emitting region.
(((6))) The information processing system according to (((5))),
   wherein the processor is configured to perform control such that the plurality of light emitting regions sequentially emit light in accordance with the light emission sequence in which adjacent light emitting regions do not successively emit light if the distance to the optical sensor becomes longer while the one light emitting region and the light emitting regions adjacent to the one light emitting region at the opposite sides thereof are sequentially emitting the light.
(((7))) The information processing system according to (((5))),
   wherein the processor is configured to perform control such that the plurality of light emitting regions sequentially emit light in accordance with the light emission sequence in which adjacent light emitting regions do not successively emit light if the distance to the optical sensor does not change for a predetermined time period or longer while the one light emitting region and the light emitting regions adjacent to the one light emitting region at the opposite sides thereof are sequentially emitting the light.
(((8))) A program causing a computer to execute a process, the process comprising:
   causing an optical sensor that has a plurality of light emitting regions capable of emitting light independently to emit light from at least one light emitting region of the plurality of light emitting regions to radiate the light onto a detection range split into a plurality of regions, and detecting a distance to a target within the detection range for each region of the detection range by receiving light reflected from the target; and
   controlling the optical sensor such that the plurality of light emitting regions sequentially emit light in accordance with a light emission sequence in which adjacent light emitting regions do not successively emit light if the target is not detected within the detection range.

The advantages achieved in accordance with the appendix will be described below.

According to the information processing system according to (((1))), the time consumed until the target is detected may be shortened, as compared with a case where the multiple regions are successively detected sequentially from an end of the detection range.

According to the information processing system according to (((2))), the time consumed until the target is detected may be shortened, as compared with a case where the multiple regions are successively detected sequentially from an end of the detection range.

According to the information processing system according to (((3))), the time consumed until the target is detected may be shortened, as compared with a case where the multiple regions are successively detected sequentially from an end of the detection range.

According to the information processing system according to (((4))), the time consumed until the target is detected may be shortened, as compared with a case where the multiple regions are successively detected sequentially from an end of the detection range.

According to the information processing system according to (((5))), the target may be readily detected.

According to the information processing system according to (((6))), another target may be readily detected assuming that the possibility of the detected target being a user is low.

According to the information processing system according to (((7))), another target may be readily detected assuming that the possibility of the detected target being a user is low.

According to the program according to (((8))), the time consumed until the target is detected may be shortened, as compared with a case where the multiple regions are successively detected sequentially from an end of the detection range.

## Claims

1. An information processing system comprising:
an optical sensor that has a plurality of light emitting regions capable of emitting light independently, the optical sensor causing at least one light emitting region of the plurality of light emitting regions to emit light to radiate the light onto a detection range split into a plurality of regions, the optical sensor being capable of detecting a distance to a target within the detection range for each region of the detection range by receiving light reflected from the target; and
a processor configured to:
control the optical sensor such that the plurality of light emitting regions sequentially emit light in accordance with a light emission sequence in which adjacent light emitting regions do not successively emit light if the target is not detected within the detection range.

2. The information processing system according to claim 1,
wherein the processor is configured to divide the plurality of light emitting regions into a plurality of groups and cause light emitting regions located at identical positions in the respective groups to emit light in sequence for each group, so as to cause the plurality of light emitting regions to emit light sequentially in accordance with the light emission sequence in which adjacent light emitting regions do not successively emit light.

3. The information processing system according to claim 2,
wherein the processor is configured to perform control to cause the light emitting regions to emit light sequentially from an end in each group.

4. The information processing system according to claim 1,
wherein the processor is configured to divide the plurality of light emitting regions into a plurality of groups and cause light emitting regions located at identical positions in the respective groups to simultaneously emit light in sequence, so as to cause the plurality of light emitting regions to emit light sequentially in accordance with the light emission sequence in which adjacent light emitting regions do not successively emit light.

5. The information processing system according to any one of claims 1 to 4,
wherein the processor is configured to perform control such that any one light emitting region of the plurality of light emitting regions and light emitting regions adjacent to the one light emitting region at opposite sides thereof sequentially emit light if the target is detected in the one light emitting region and the distance to the optical sensor subsequently becomes shorter than when the target is detected in the one light emitting region.

6. The information processing system according to claim 5,
wherein the processor is configured to perform control such that the plurality of light emitting regions sequentially emit light in accordance with the light emission sequence in which adjacent light emitting regions do not successively emit light if the distance to the optical sensor becomes longer while the one light emitting region and the light emitting regions adjacent to the one light emitting region at the opposite sides thereof are sequentially emitting the light.

7. The information processing system according to claim 5,
wherein the processor is configured to perform control such that the plurality of light emitting regions sequentially emit light in accordance with the light emission sequence in which adjacent light emitting regions do not successively emit light if the distance to the optical sensor does not change for a predetermined time period or longer while the one light emitting region and the light emitting regions adjacent to the one light emitting region at the opposite sides thereof are sequentially emitting the light.

8. A program causing a computer to execute a process, the process comprising:
causing an optical sensor that has a plurality of light emitting regions capable of emitting light independently to emit light from at least one light emitting region of the plurality of light emitting regions to radiate the light onto a detection range split into a plurality of regions, and detecting a distance to a target within the detection range for each region of the detection range by receiving light reflected from the target; and
controlling the optical sensor such that the plurality of light emitting regions sequentially emit light in accordance with a light emission sequence in which adjacent light emitting regions do not successively emit light if the target is not detected within the detection range.

9. An information processing method comprising:
causing an optical sensor that has a plurality of light emitting regions capable of emitting light independently to emit light from at least one light emitting region of the plurality of light emitting regions to radiate the light onto a detection range split into a plurality of regions, and detecting a distance to a target within the detection range for each region of the detection range by receiving light reflected from the target; and
controlling the optical sensor such that the plurality of light emitting regions sequentially emit light in accordance with a light emission sequence in which adjacent light emitting regions do not successively emit light if the target is not detected within the detection range.
